Europäisches Patentamt

(19) European Patent Office

Office européen des brevets

(11) Publication number: **0 246 054**
**A2**

(12) # EUROPEAN PATENT APPLICATION

(21) Application number: **87304172.7**

(22) Date of filing: **11.05.87**

(51) Int. Cl.³: **H 03 M 1/22**

(30) Priority: **12.05.86 JP 106765/86**
**07.07.86 JP 157980/86**

(43) Date of publication of application:
**19.11.87 Bulletin 87/47**

(84) Designated Contracting States:
**DE FR GB**

(71) Applicant: **KABUSHIKI KAISHA EMPIRE AIRPORT SERVICE**
**34-6, Shiba 5-chome, Minato-ku**
**Tokyo(JP)**

(72) Inventor: **Miyamoto, Takehiko**
**6-19, Shimoshakujii 1-chome Nerima-ku**
**Tokyo(JP)**

(74) Representative: **Kennedy, Victor Kenneth et al,**
**G.F. REDFERN & CO. Marlborough Lodge 14 Farncombe Road**
**Worthing West Sussex BN11 2BT(GB)**

(54) Position encoders and methods of their manufacture and use.

(57) Position encoders include a rotary disc or sliding member (20) for moving by an amount proportional to movement of a body to be controlled and having a recording material layer on a surface thereof, and a write/read head (10) or sensor (106) arranged at a position opposing the layer for writing position information (X,Y,Z) into the data-carrier layer that is coupled to the body to be controlled and for reading written information therefrom. The body is positioned at a control position, control position information (D) for controlling the body is written by a writing portion of the magnetic head write-in transducer at a corresponding position on the rotary disc or slide, and the written control position information is subsequently detected by a reading portion (11) of the magnetic head or sensor, thereby detecting arrival of the body to be controlled at a desired control position.

FIG. 1

## POSITION ENCODERS AND METHODS OF THEIR MANUFACTURE AND USE:

This invention relates to position encoders capable of establishing the relative position of a data carrier relative to a support body with high accuracy, and also relates to methods of manufacturing such encoders, and to using such encoders.

It will be assumed that the data carrier is secured to move with a body that is to be controllably moved on a predetermined path relative to a support body, but obviously the relationship can be reversed.

Furthermore, it is to be understood that the relative movement is not random, but follows some predetermined path governed by the structure, for example a rotary disc on a shaft, or a linear slide in a groove on a support body.

Along with the general advances that have recently been made in the field of robotics and machine automation, encoders which serve as devices for detecting rotational and linear positions have come into wide use for the purpose of control in such robots and machines. A great variety of such encoders are available. Incremental rotary encoders are the most commonly employed rotary encoders for measuring the displacement of a rotational angle, and such an encoder will now be described.

Rotary encoders are presently available on the market in two main types, namely optical and magnetic. However, recent progress in the field of digital technology has produced a need for rotary or slide encoders having high resolution and reliability.

2

For example, in the magnetic-type of position encoder, magnetic graduations indicative of position information are written on a track or tracks formed on a rotary disc, and the graduations are read by a magnetic head, which responds by producing output signals having a rectangular waveform which enable the relative positions to be detected, as will be described hereinafter.

However, in order to obtain a high resolution with a disc of a given shape and size, the pitch of the signal generating sources must normally be reduced. This leads to a weakening of the generated signals and to a deterioration in the S/N ratio, resulting in a general decline in reliability. In addition, a high processing speed may be required, and the associated control circuitry then becomes complicated and costly. The processing speed can be lowered by reducing the number of output pulses per revolution, but the attainable resolution declines and precision in positioning therefor suffers if this reduction is adopted.

By way of example, consider a rotary encoder which generates 1000 pulses per revolution. If a motor on which such an encoder is mounted is a high-speed motor that rotates at 6000 rpm, the output pulses from the encoder will have a frequency of 100 KHz. By comparison, a rotary encoder having a resolution of 10,000 pulses per revolution will produce output pulses having a frequency of 1 MHz at the same rotational speed of 6000 rpm.

In order to use such a high-resolution encoder mounted on a high-speed motor, as is frequently necessary, a high-performance computation control circuit capable of executing processing at a very high speed must be provided to process the output pulses from the encoder. Such processing is not readily possible with an ordinary microcomputer.

Moreover, no matter how much the pitch is reduced to bring the graduations closer together and raise resolution, the control position may at best be merely an approximate position, since it cannot be assumed that there will always be a graduation in an ideal position, to precisely agree with the required position information.

This discussion of rotary-type encoders should not obscure the fact that there are many forms that can be used where special requirements exist, such as linear encoders with a sliding member, or any combination which satisfies any required predetermined positional relationship law.

One object of the present invention is to provide a position encoder in which position information can be written at any required position, and the position information read and detected, whereby desired position control can be achieved with high precision, reliably and efficiently, using any of the various systems for recording graduations and reading out at high speed that are now becoming available.

Thus, according to one aspect the present invention consists in a position encoder comprising: a body that is to be controlled, movable in a predetermined manner on a support body; a data-carrier on said body mounted to move by an amount proportional to that of the body that is to be controlled; a data input/output head arranged on said support body adjacent said data-carrier and adapted to write position information onto the data-carrier surface and read written information therefrom; characterised by means for writing control position information regarding control of the body that is to be controlled by use of said head at a corresponding position on said

4

data-carrier; and means by which the written control position information is read by use of said head to detect and respond as required when said body to be controlled arrives at a given control position, relative to the support body, during use.

According to another aspect the present invention consists in a method of using an encoder for reading out a position information signal corresponding to a given positional relationship of a body to be controlled, characterised by the following steps:

an information carrier such as a rotary disc which rotates or moves in the predetermined manner by an amount that corresponds to rotation of the body to be controlled has position information written in at a predetermined circumferential surface on a radius of rotation or the equivalent;

first reading means read the position information written into said rotary disc or the like;

writing means write position information separate from that of the first-mentioned position information, into said rotary disc or the like at any desired position; and

second reading means read the position information written by said writing means.

According to yet another aspect the present invention consists in a method of manufacturing a position encoder, characterised by the steps of:

(a) assembling a position encoder main unit which includes a control circuit and a rotary disc or the equivalent body to be controlled;

(b) mounting the assembled position encoder on a support body and coupling it to a driving source;

(c)     positioning the body to be controlled at a desired position; and

(d)     subsequently writing position information on the rotary disc at a position resulting from said positioning.

Thus, in embodiments of the invention, precise position information can be written, in a state where the encoder is mounted on an object under control, after the object is positioned at a control position, making very accurate positioning possible.

Other features and advantages of the present invention will be apparent from the following description and Claims, taken in conjunction with the accompanying drawings, in which any similar parts are identified by identical reference characters.

The invention will now be described with reference to the drawings, in which:-

Figure 1 is a simplified sectional view illustrating one exemplary embodiment of a rotary position encoder constructed in accordance with the present invention;

Figure 2 is a schematic perspective view showing the relationship between a rotary disc and magnetic head in the embodiment of the invention shown in Figure 1;

Figure 3 is an explanatory set of waveform diagrams illustrating the reading of position information as used according to the above-described embodiment of the invention;

Figure 4 is a flow-diagram of an encoder manufacturing process as used in a preferred embodiment of the invention;

Figure 5 is an explanatory set of waveform diagrams illustrating the reading of position information in a known form of encoder;

Figure 6 is a simplified schematic view illustrating a write/read head and a controller suitable for use in embodiments of the present invention;

Figure 7 is a detailed circuit diagram of a write/erase control circuit suitable for the write/read head shown in Figure 6;

Figure 8 is a circuit diagram of the read head control for the described embodiment of the invention;

Figure 9 is a schematic view of a conventional optical-type rotary disc; and

Figure 10 is a perspective view showing the relationship between the sensors of a conventional optical rotary disc and a magnetic head as shown in Figure 2.

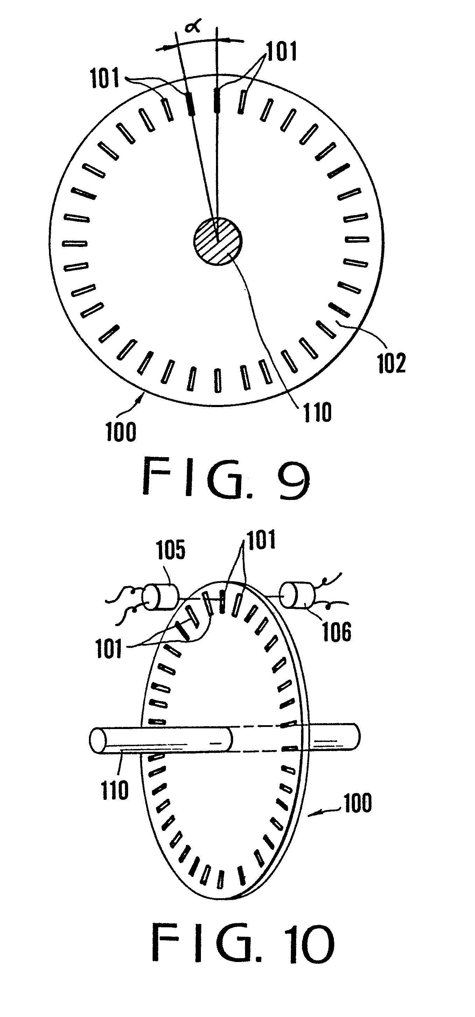

To facilitate an understanding of the invention a known construction of an optical disc used in a conventional optical rotary position encoder of the type most widely employed in the art will be described with reference to Figures 9 and 10. An optical disc 100 is fixedly secured on a drive shaft 110 which rotates in response to movement of an object under control, the shaft 110 passing through the centre of the disc 100. The optical disc 100 is formed with slits 101 through which a beam of light can pass, the light beam being blocked by the solid portions 102 of the disc body between the slits. The slits 101, which extend radially in the disc 100, are arranged evenly around the entire circumference of the disc, on a track at a prescribed radius from the centre thereof and are regularly spaced at a predetermined angle α. The slits 101 and intervening solid portions 102 need only transmit and block the light beam, and can consist of alternately arranged transparent and opaque portions, respectively.

As shown in Figure 10, the optical disc 100 is interposed between a light-emitting element 105, which produces the aforementioned light beam, and a light-receiving element 106 arranged as a sensor opposite the source 105 at the portion of the disc where the slits 101 are provided. When the optical disc 100 rotates, the light beam from the light-emitting element 105 passes through the slits 101 to impinge upon the light-receiving element 106 and is blocked from the light-receiving element 106 by the solid portions 102 between the slits 101. Thus, the light-beam from the light-emitting element 105 is allowed to impinge intermittently upon the light-receiving element. By thus sensing the light beam, the light-receiving element 105 makes it possible to detect the amount by which the optical disc 100 rotates.

In the case of a magnetic-type rotary position encoder, magnetic graduations are recorded on a rotatable disc in advance by applying a highly coercive magnetic material to the disc at positions corresponding to the circumferential track on which the slits 101 of optical disc 100 shown in Figure 9 are located, or by applying the magnetic material to the peripheral surface of the disc at the above-mentioned positions. These magnetically recorded graduations are read by a magnetic head arranged at a predetermined position adjacent the circumferential track or at a predetermined position adjacent the peripheral surface of the disc, as the case may be. The amount of disc rotation is detected by counting the number of pulses produced in accordance with the amount of disc rotation.

However, the spacing between adjacent slits in the optical system, or between adjacent magnetic graduations in the magnetic system is a certain fixed angle, denoted by $\alpha$ in Figure 9, and the accuracy with which an angular position can be expressed is decided by this angle $\alpha$. In other words, expressing a position within the angle $\alpha$ (i.e. obtaining a position detection accuracy smaller than $\alpha$ ) is impossible. In order to improve accuracy, the slit pitch must be reduced (i.e. the number of slits must be increased) to reduce the angle $\alpha$.

Mechanically speaking, this demands higher machining and assembly precision. Electrically speaking, reducing the size of the slits results in less light passing through the slits and worsens the S/N ratio. Consider a case where an optical-type incremental rotary position encoder is used, and the position is to be detected at a point where the encoder shaft rotates through 90° and rotation is stopped at this point. If the encoder emits 400 pulses per revolution, then rotation should be stopped at a position detected to be 100 pulses from a reference point. However, only the 100th pulse is actually needed, and the first 99 pulses are not directly required. Nevertheless, all of these pulses must be constantly monitored in the conventional arrangement. Furthermore, if it were required to stop rotation at 89°, and not the 90° position, this cannot be accomplished because there is no slit at 89°. Thus, stopping rotation at any arbirary position is impossible.

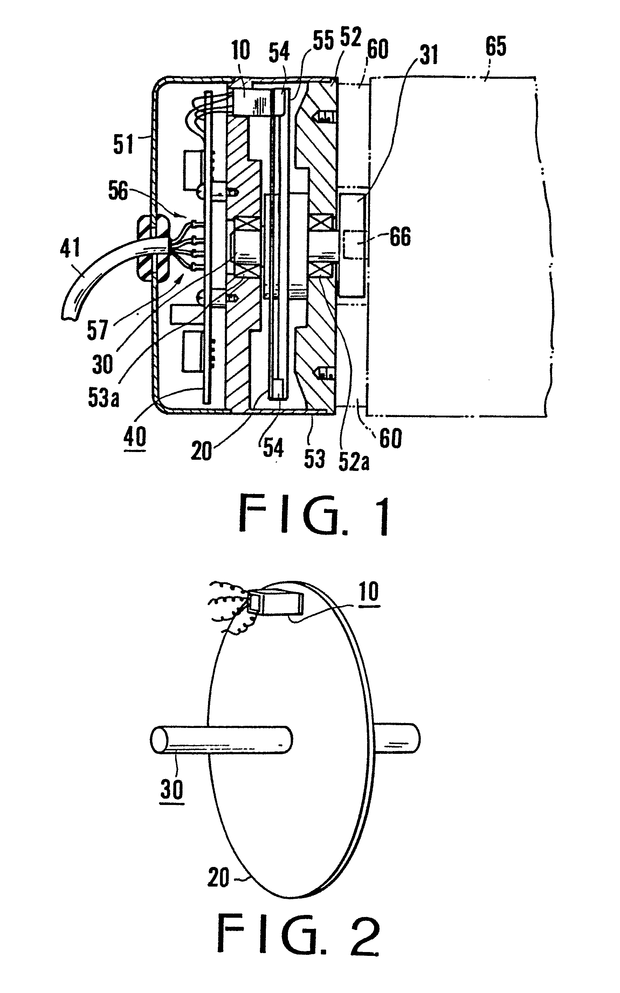

Figure 2 illustrates the positonal relationship between a rotary disc and a magnetic head according to the embodiment of the invention shown in Figure 1. A write/read head 10 is mounted adjacent a magnetic disc 20 and a drive shaft 30 carries the disc, and rotates by an amount corresponding to the amount of movement of an object or body to be controlled. The surface of the disc 20 is coated with a magnetic material possessing a strong coercive force, at least on the circumferential portion thereof having a predetermined radius corresponding to the slits 101 described with reference to Figure 9. The magnetic head is disposed at a position opposing the magnetic material-coated surface, as shown in Figure 2. Position information is recorded on the disc 20 at desired positions in the form of a magnetic signal by the magnetic head 10. Locations from which this recorded position information is subsequently read serve as desired locations. It should be noted that the position information on the magnetic disc 20 is not limited to desired position information; control can be performed in such a manner that reference position information is written onto another track, or such that reference position information is written onto the disc in advance, and desired position information written in subsequently. If the rotary position encoder is used for direct positional control of an object such as a robot arm that does not make more than one revolution, the encoder can be greatly simplified and improved in accuracy.

As a result, control for designating a stopping position can be executed with great accuracy, and it is possible to realize a rotary position encoder equivalent to one having slits recorded at a theoretically limitless pitch.

10

Furthermore, if a magnetic recording is made on the disc only at the required locations, unnecessary detection signals will not be emitted, and control circuits for counting these signals can be dispensed with, unlike the case with the conventional rotary encoder. Arrival at a desired position can be determined by the arrival of a single detection signal. Accordingly, in a control unit using the position encoder, interrupt pending processing is executed for the required signal, during which time other processing and control can be performed. This enables a computer or the like to be utilised very effectively and makes it possible to greatly simplify the control program.

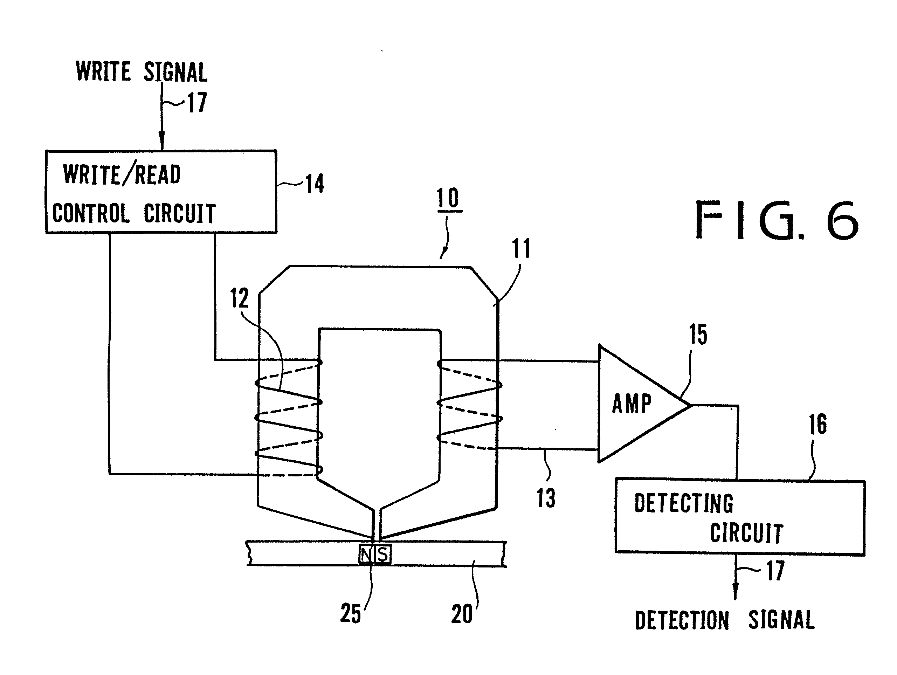

If position information is written not only at the required positions but also on other tracks, the magnetic head 10 can be equipped with a read head portion for the required number of tracks, e.g. for three tracks, and a write/read head for one control track, control being performed in such a manner that the position information X, Y and Z shown in Figure 5 is read by the read head portion in known manner.

Figure 5 is a timing chart for a known three-track marking, showing on the left the output for forward rotation, and on the right the output obtained with reverse rotation. The direction of rotation can be identified by comparing the two signals X and Y. When the signal Z is emitted, this indicates that the rotary disc is at a one-revolution initial position. This will be discussed in greater detail later.

The following description will deal with an encoder in which the magnetic head 10 has a three-track read head portion and a single-track write/read head portion.

In Figure 1, the rotary disc 20 on the drive shaft 30 is shown, together with a control substrate 40 for write/read control of the magnetic head 10, an interface cable 41, a protective cover 51 for protecting the control substrate 40, with a support base 52 and main support base 53 rotatably supporting the drive shaft 30. Further, a ring-shaped, sponge-like resilient body 54 is provided for bringing the magnetic disc 20 into pressure contact with the magnetic head 10 at a predetermined contact pressure, and a back plate 55 is provided for supporting the resilient body 54.

The magnetic head 10 is equipped with a three-track read head portion and a single-track write/read head portion. Periodic magnetic graduations, X and Y, are each spaced apart at a certain fixed angle $\alpha$, have been written before assembly, mutually displaced rotationally in well-known manner on two tracks of the magnetic surface of the rotary disc 20 at the position of the read head of magnetic head 10, and a reference position signal Z indicating a reference position of the magnetic disc is written on the magnetic surface of the disc at the position of the third read track. The signals X, Y and Z are as shown in Figure 5, and similar to prior art arrangements.

In accordance with this embodiment of the present invention, position information D is recorded in addition to the above-mentioned conventional magnetically recorded graduations, by forming a magnetic signal at any arbitrary position on a magnetic track corresponding in position to the write/read head portion of the magnetic head 10. Thereafter, this previously recorded position information D and the read positions of the position information X and Y written

12

in the conventional manner are investigated, whereby desired position detection and positioning may be carried out.

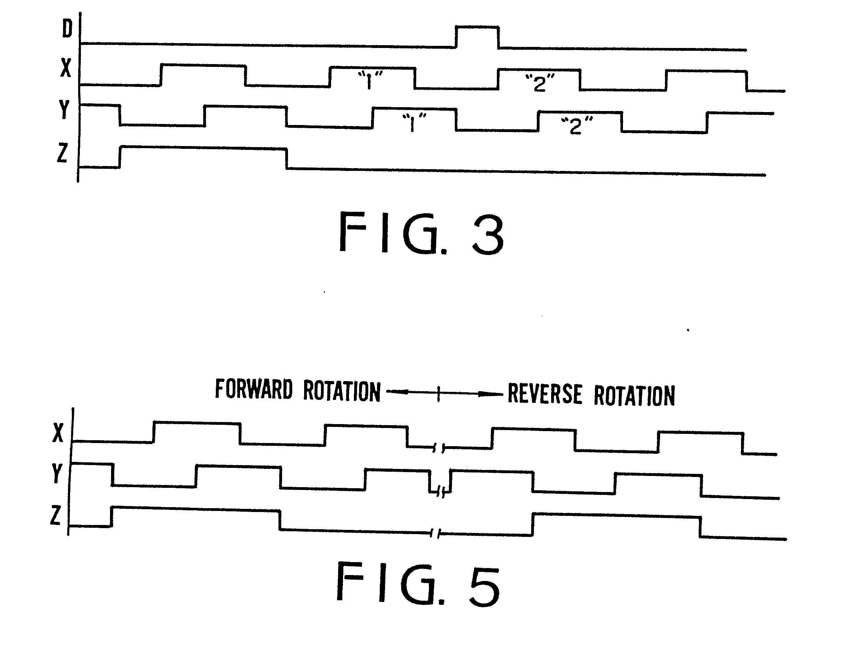

An explanatory set of waveform diagrams forming a reading timing chart in accordance with this embodiment is illustrated in Figure 3. The signal D is an additional new read pulse of a magnetic signal written in by the magnetic head 10 of this embodiment. It should be noted that the timing chart of Figure 3 holds for forward rotation, and reverse rotation will produce X-Y displacement as already described with reference to Figure 5.

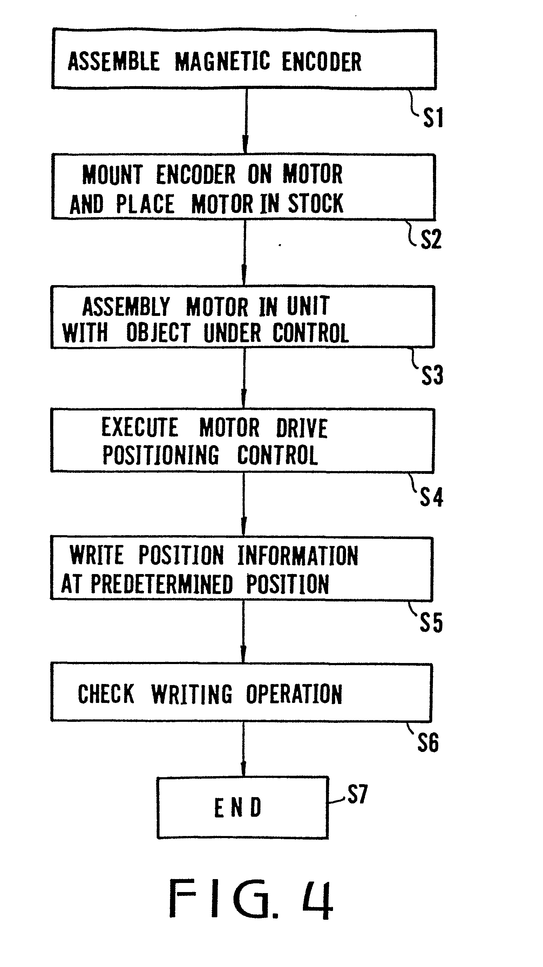

The rotary encoder is assembled in a state where the magnetically recorded graduations are written on the rotary disc 20 in the three tracks for X, Y and Z by any known method. This forms step S1 of Figure 4. The magnetically recorded graduations need not have the resolution desired by the end user. It is sufficient to provide common magnetic graduations of relatively coarse precision in a range that will assure high reliability on read-out. This is the condition of the rotary position encoder when made available to users, e.g. servo-motor manufacturers, representing step S2 in Figure 4. The servo-motor manufacturer installs these position encoders in the servo-motors on an assembly line, without needing to take a customer's specifications into account. These servo-motors are then kept in stock, and issued when sales are made. Specifically, the encoder main base 53 and the support base 52 are secured to a servo-motor 65 via a mounting fitting 60, as shown by broken lines in Figure 1, and the drive shaft 30 is connected to a drive shaft 66 of the servo-motor 65. This is the condition in which the servo-motors are kept in stock.

When a servo-motor has been delivered to a customer from stock, the customer, in accordance with his required specifications, unites the motor with the object or body that is to be controlled, represented by step S3 in Figure 4, and the motor is driven to actually move the object or body to the desired position. For example, in an apparatus for controlling an object through a well-known teaching function, the object is positioned by being moved to the desired position manually or in small increments. When the object has been brought to the desired position to end the positioning operation, a magnetic head write control circuit on the control substrate 40 is energised to write the magnetic graduations into the rotary disc 20 at the afore-mentioned position, represented by step S5 in Figure 4. It will suffice if an object control unit, not shown, stores the positional relationship between the position written at the magnetic graduation and the previously written magnetic graduations X, Y and Z. For example, in Figure 3, the position at which the magnetic graduation D is written lies between the first and second X pulse following the detection of a Z pulse and between the first and second Y pulses following the detection of the Z pulse.

To position the object at the desired position by driving the motor, the read signals X, Y and Z are monitored to prepare for the arrival of the first X pulse and first Y pulse by detection of a Z pulse following detection of a desired number of rotations. If the motor rotates at high speed, a required amount of deceleration is applied before the appearance of the X and Y pulses. When X and Y pulses are detected for the first time, the D track is then monitored. When the D pulse is detected, positioning of the object

14

at the desired position is complete. At this time a check is performed to make sure that the object has been brought to the desired position, as represented by step S6 in Figure 4. If the object has been brought to the desired position, control for the writing of information on the rotary disc 20 is ended, as represented by step S7 in Figure 4.

If the result of position control is that the object is not at the desired position, the magnetic graduation which has been written in the D track is erased and re-written after any necessary re-adjustments. A rotary position encoder whose specifications conform to the needs of the customer can thus be provided.

When the above-described write control operation ends, it may be desirable to effect control in such a manner that the write control circuit on control substrate 40 cannot be readily energised. This prevents any subsequent inadvertent writing from taking place.

The write/read head portion is equipped with an erase head for simultaneously erasing position information.

In accordance with the present embodiment described above, the magnetic graduations of X, Y and Z are written beforehand at a high output level, at a pitch which does not require a high resolution and does not involve the likelihood of recognition error. It will suffice if this is applied commonly for all encoders, irrespective of the various positional accuracies demanded by customers. This makes it possible to reduce the number of component parts. By writing position information into a desired position by the write/read head portion, highly precise position control can be carried out and it is possible to realise a rotary encoder equivalent to one having magnetic graduations recorded at a theroretically limitless pitch, or infinite number of graduations per revolution.

Accordingly, a rotary position encoder which emits pulses at a low frequency can be obtained, even if the motor has a high rate of rpm and a high resolution is required. If a conventional rotary position encoder having a resolution of 10,000 pulses per revolution is mounted on a high-speed motor that rotates at 6000 rpm, the pulses emitted by the encoder will have a frequency of 1 MHz. However, in accordance with the illustrated embodiment of the invention, position information indicative of the D position can be written at the necessary position even if X and Y pulses are written at a resolution of 100 or less pulses per revolution. The position encoder can be provided with a positioning accuracy greater than that of an orthodox encoder whose resolution is higher than 10,000 pulses per revolution. Thus, it is possible to realise a simple positioning control unit which does not require high speed.

The control procedure will now be described for a case where the magnetic head 10 is equipped with only a single-track write/read head to only perform magnetic recording at a required location.

Figure 6 is a block diagram showing the magnetic head 10 and the control circuit on the control substrate 40. The magnetic head 10 is provided with a read coil 11 and a write/read changeover drive coil 12. When a write signal 17 arrives from a control unit (not shown) a write/read control circuit 14 causes a strong current to flow through the write/read changeover drive coil 12, thereby locally magnetising a magnetic layer on the rotary disc 20, as shown at 25, for example. When the write signal 17 terminates, the strong current that was supplied for the writing operation ceases to flow.

16

It should be noted that control can be performed to effect magnetisation only at the leading edge of the write signal 17.

In the absence of the write signal 17, a current that is too weak to demagnetise the magnetised position information or mark 25 is fed through the write/read changeover drive coil 12. The state of a magnetic flux generated in the core 11 of the magnetic head 10 by this weak current is monitored at all times by the read coil 11, producing a signal representing the detected flux level, which is amplified by an amplifier 15, and passed to a detecting circuit 16 to produce a detection signal 17 that performs a monitoring operation to determine if the flux should change by an amount in excess of a predetermined range. When the previously magnetised position information 25 arrives at a position below the face of the magnetic head 10, as shown in Figure 6, a change is produced in the flux in core 11. This is detected by the detecting circuit 16 via the read head 11 and amplifier 15, and causes the circuit 16 to emit a detection signal 17. It should be noted that the detecting circuit 16 is well-known and need not be described here.

In a case where the above information is recorded together with a reference position, the recording of the reference position and the other recordings are compared and the direction of magnetisation is reversed or the strength of magnetisation is increased in order to distinguish between the reference position graduation marks and other recorded position graduation marks.

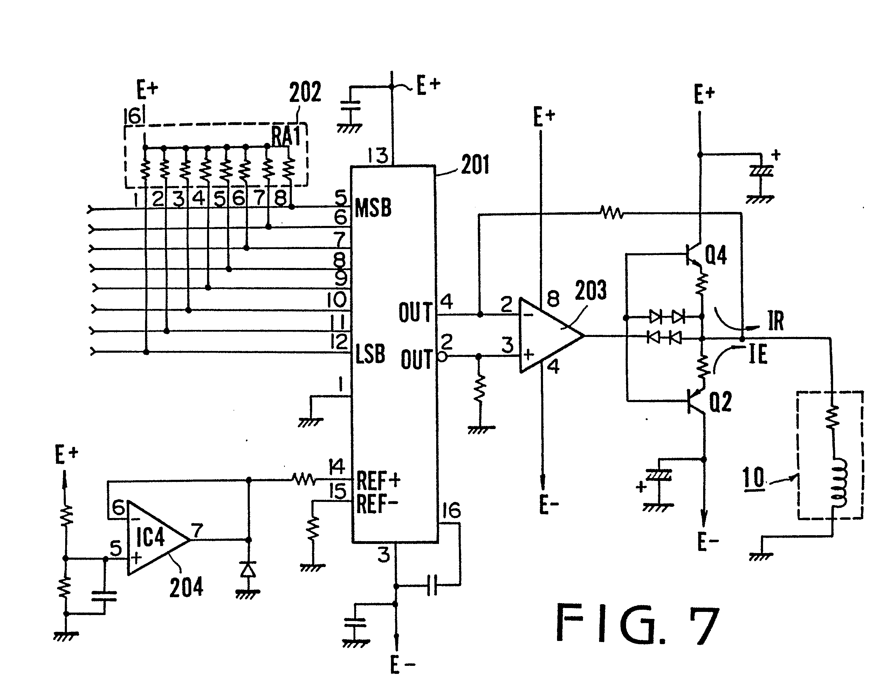

Figure 7 illustrates an example of a position circuit of the write/read control circuit 14. The head 10 is shown by its equivalent circuit, comprising resistance and reactance components, as shown in Figure 7. In the present embodiment, the write head portion of the write head 10 is used for both recording and erasing. The recording current $I_R$ is produced by conduction of a transistor Q4 and the erasing current $I_E$ in response to conduction of a transistor Q2. In this embodiment, $|I_R| = |I_E|$.

In Figure 7, a D/A converter 201 is used as the IC for head drive, a desired example of which is the uPD624C manufactured by NEC. Two ICs 203 and 204, a desired example of which is the µPD4570C, manufactured by NEC, serve as operational amplifiers. Transistors Q2 and Q4 are preferably the ISA1154KA and 2SC2721KA, respectively.

The output value changes in accordance with digital input values MSB - LSB applied to the D/A converter 201, thereby making it possible to select a recording output or an erasing output.

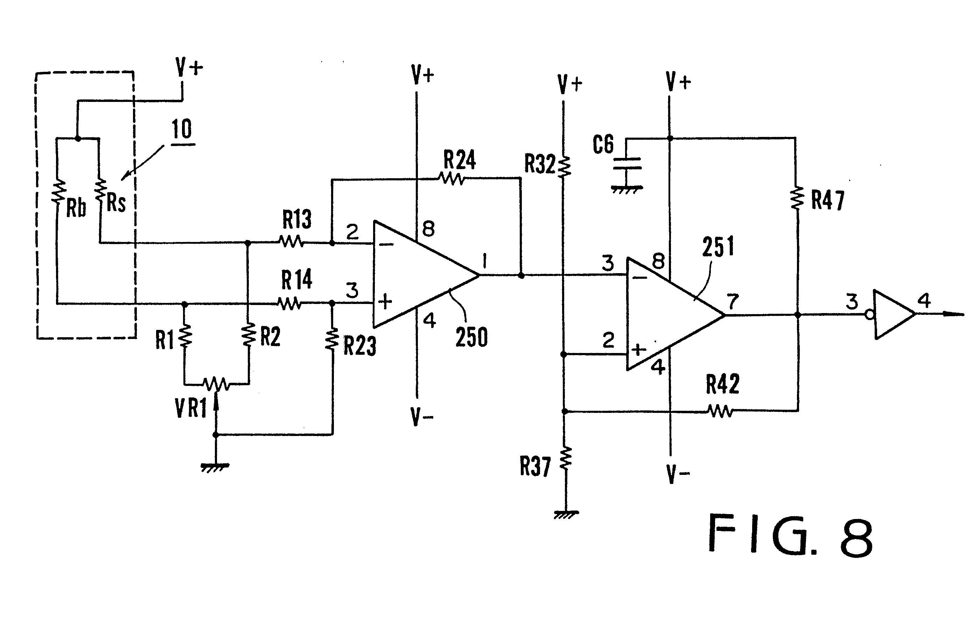

Figure 8 illustrates details of the detecting circuit of the read head for reading position information written by the write head portion, or prewritten position information and the like.

Since the basic circuit for detecting the change in flux, in the case where the read head has the construction shown in Figure 6 is well-known, further description of this circuit stage is considered unnecessary. An example where the read head is constituted by an MR element will now be described with reference to Figure 8.

18

The MR element can be illustrated in the form of an equivalent circuit having separate resistive arms $R_b$ and $R_s$, as as shown in Figure 8. When no signal is being detected, the following will hold, by way of example:

$$R_{b0} = R_{s0} \pm 20\% \text{ (where } R_s = R_{s0} \text{ and } R_b = R_{b0}).$$

On detection of a signal, then $R_b = R_{b0}$ and $R_s = R_{s0} (1 - \alpha)$ will hold, and $\alpha$ will have a value of 0.02.

In order to detect a change in the value of $\alpha$ effectively, a bridge circuit is constructed incorporating $R_b$, $R_s$ and external resistances $R_1$, $R_2$ and $VR_1$. A change in the input potential of an amplifier 250 due to a change in the resistance ratio of $R_b$ relative to $R_s$ is amplified by the amplifier 250, whose output is then converted into a binary value, inverted and amplified by an inverting amplifier 251. The output of this amplifier 251 is then converted back into an analogue potential by an inverter 252 before being fed out.

In the foregoing description, the invention has been described applied to a rotary position encoder, which is mounted on the drive shaft of a motor or the like. However, movement of the object or body that is to be controlled is not limited to related rotary movement of a disc. If the object is one which undergoes linear motion, for example a linear encoder can be utilised by arranging a magnetic head at a predetermined position opposing a detecting plate, which is coated with a magnetic stripe, and adapted to move in accordance with the movement of the object or body that is to be controlled.

Position encoders of the type described above can of course be used with all forms of drive mechanisms for positional control of various industrial machines and robots. They can be employed generally in positioning mechanisms for all types of moving objects.

In accordance with the present invention as described above, there is provided a simply controllable position encoder capable of detecting the desired position of an object with great accuracy using magnetic recording techniques.

However, the graduation marks can be formed optically, for example by optical write/read systems such as that using ablative photo-decomposition with a photo-lithographic data-carrier and an ultra-violet laser, or a data-carrier that can be written on by causing a change in reflectivity or a reversible conversion of a crystalline surface to an amorphous state, which all permit the use of an optical sensor for read-out in known manner. If provision for amendment of a positional graduation mark is not required, then the data-carrier can have a graduation formed by use of a laser to burn out a hole, and optical sensing as described with reference to Figure 9 could then be used.

CLAIMS:

1.      A position encoder comprising:

a body that is to be controlled, movable in a predetermined manner on a support body;

a data–carrier on said body mounted to move by an amount proportional to that of the body that is to be controlled;

a data input/output head arranged on said support body adjacent said data–carrier and adapted to write position information onto the data-carrier surface and read written information therefrom;

characterised by

means (10) for writing control position information regarding control of the body that is to be controlled by use of said head at a corresponding position on said data–carrier (20); and

means (11) by which the written control position information is read by use of said head to detect and respond as required when said body to be controlled arrives at a given control position, relative to the support body, during use.

2.      An encoder as claimed in Claim 1, characterised in that the written position information includes reference position information (X,Y,Z) and desired position information (D).

3.      An encoder as claimed in Claim 1 or Claim 2,
characterised in that the surface of said data-carrier (20)
carries a magnetisable layer and said head (10) is an electromagnetic head.

4.      An encoder as claimed in Claim 1 or Claim 2,
characterised in that said data-carrier is photo-sensitive,
and said head incorporates a light source (105) and a photo-sensor
(106).

5.      An encoder as claimed in Claim 4, characterised in that
the light source (105) is a laser.

6.      An encoder as claimed in any preceding Claim,
characterised in that said body to be controlled is a
rotary disc (100).

7.      An encoder as claimed in any one of Claims 1 to 5,
characterised in that  the body to be controlled is a slide mounted
in a groove on said support body.

8. A method of using an encoder as claimed in any preceding Claim, for reading out a position information signal corresponding to a given positional relationship of a body to be controlled, characterised by the following steps:-

an information carrier such as a rotary disc (20) which rotates or moves in the predetermined manner by an amount that corresponds to rotation of the body to be controlled has position information (X,Y,Z) written in at a predetermined circumferential surface on a radius of rotation or the equivalent;

first reading means read the position information written into said rotary disc (56) or the like;

writing means write position information (D) separate from that of the first-mentioned position information, into said rotary disc or the like at any desired position (55); and

second reading means read the position information written by said writing means (56).

9. A method of using an encoder as claimed in Claim 8, characterised in that the rotary disc or the like has a magnetic layer on a predetermined circumferential surface thereof on the radius of rotation or an equivalent line, as the case may be, said position information is stored in a magnetic memory written into the magnetic layer, said first and second reading means include a read magnetic head for reading the magnetic memory written into the magnetic layer, and a write magnetic head enters position information into the magnetic layer at any desired position thereof, to provide output position information in the form of a pulse signal.

10.        A method of manufacturing a position encoder,as claimed in any one of Claims 1 to 7, <u>characterised by</u> the steps of:

(a)        assembling a position encoder main unit which includes a control circuit and a rotary disc or the equivalent body to be controlled;

(b)        mounting the assembled position encoder on a support body and coupling it to a driving source;

(c)        positioning the body to be controlled at a desired position; and

(d)        subsequently writing position information on the rotary disc at a position resulting from said positioning.

11.        A method of manufacturing a position encoder as claimed in any one of Claims 1 to 7, <u>characterised by</u> the steps of:

(a)        assembling a magnetic encoder main unit which includes a control circuit and a rotary disc (20) on which position information (X,Y,Z) has been written beforehand at a predetermined pitch (51);

(b)        mounting the magnetic encoder thus obtained on a driving source (52);

(c)        assembling the driving source (65), on which the magnetic encoder has been so mounted into a unit with a body whose position is to be controlled (53);

(d)        positioning the object thus assembled at a desired control position (54); and

(e)        writing position information (D) for detection in a manner which is separate from that for the position information written beforehand, on a position of the thus positioned magnetic disc (55).

FIG. 1

FIG. 2

FIG. 3

FIG. 5

FORWARD ROTATION ——|—→ REVERSE ROTATION

```
┌─────────────────────────────────────┐
│   ASSEMBLE  MAGNETIC ENCODER         │
└─────────────────────────────────────┘
                    │              ⌐S1
                    ▼
┌─────────────────────────────────────┐
│   MOUNT  ENCODER  ON MOTOR           │
│   AND  PLACE  MOTOR IN STOCK         │
└─────────────────────────────────────┘
                    │              ⌐S2
                    ▼
┌─────────────────────────────────────┐
│   ASSEMBLY  MOTOR  IN UNIT           │
│   WITH  OBJECT  UNDER CONTROL        │
└─────────────────────────────────────┘
                    │              ⌐S3
                    ▼
┌─────────────────────────────────────┐
│   EXECUTE  MOTOR  DRIVE              │
│   POSITIONING  CONTROL               │
└─────────────────────────────────────┘
                    │              ⌐S4
                    ▼
┌─────────────────────────────────────┐
│   WRITE  POSITION  INFORMATION       │
│   AT PREDETERMINED  POSITION         │
└─────────────────────────────────────┘
                    │              ⌐S5
                    ▼
┌─────────────────────────────────────┐
│   CHECK  WRITING  OPERATION          │
└─────────────────────────────────────┘
                    │              ⌐S6
                    ▼
          ┌──────────────────┐  ⌐S7
          │      E N D        │
          └──────────────────┘
```

# FIG. 4

FIG. 6

WRITE SIGNAL
~17

WRITE/READ CONTROL CIRCUIT ~14

10

11

12

AMP 15

13

16 DETECTING CIRCUIT

~17

DETECTION SIGNAL

25 20

FIG. 7

0246054

FIG. 8

0246054

FIG. 9

FIG. 10